# EUROPEAN PATENT APPLICATION

(11) **EP 1 353 233 A2**
(43) Date of publication of application: **15.10.2003**
(21) Application number: 03252183.3
(22) Date of filing: 07.04.2003
(51) Int. Cl.: G03F 7/20

(54) **Lithographic apparatus and device manufacturing method**

(30) Priority: 09.04.2002 EP 02252526
(71) Applicant: ASML Netherlands B.V., 5503 LA Veldhoven (NL)
(72) Inventor: Rossing, Harm Roelof, 6536 AL Nijmegen (NL); Van den Brink, Marinus Aart, 5066 CM Moergestel (NL); George, Richard Alexander, 5691 HN Son en Breugel (NL)
(74) Representative: Leeming, John Gerard

(57) **Abstract**

A lithographic projection apparatus 1 having at least two substrate holders WT₁, WT₂ includes means for reducing effects of differences in images caused by differences between the two substrate holders. The apparatus 1 includes internal or external means for identifying a substrate and associating it with a respective one of the substrate holders. It then ensures that either the substrate is processed on the appropriate holder or that correction is applied to the imaging. In an alternate embodiment, the substrate is associated with a respective one of the substrate holders and is consistently processed using that substrate holder without further identification steps.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate holder for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate holder parallel or anti-parallel to this direction; since, in general, the projection system will have a magnification factor M (generally < 1), the speed V at which the substrate holder is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate holders (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

The inventors have investigated performance of dual stage lithographic apparatus and have determined that there may be performance problems with imaging a single substrate in steps performed on the different stages within the same machine. For example, the inventors have determined that one component of overlay error is an error between stages. In experiments, this error component was determined to be on the order of 1-10nm, even for very precisely matched stages. As requirements for overlay performance increase, eliminating an error of even a few nanometers may be exceptionally valuable.

It is an object of the present invention to allow improved image performance in lithographic processes using dual-stage lithography apparatus.

This and other objects are achieved according to the invention in a lithographic apparatus as specified in the opening paragraph, characterized in that the apparatus comprises means for controlling imaging such that when imaging a second pattern onto a substrate having a first pattern imaged thereon, effects of differences between the two substrate holders are reduced.

By accounting for differences between the substrate holders, the apparatus according to the present invention can achieve improved imaging performance. The inventors have been able to achieve overlay performance improvement of several nanometers. Manufacture of stages giving this level of stage to stage overlay performance would be extremely costly, if it were possible at all. Thus, the present invention allows increased performance without additional engineering and manufacturing expenses.

The means for controlling imaging may comprise, for example, a means for ensuring that a substrate on which a first pattern has been imaged will be imaged with a second pattern using the same one of the two substrate holders. That is, for each substrate, critical process steps will be performed on the same stage.

Alternately, the means for controlling imaging may comprise, for example, means for adjusting imaging to account for differences between the two substrate holders.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;
- providing a first and second substrate holder to hold the substrate during imaging, characterized by controlling the imaging of a second pattern onto a substrate containing a first pattern to reduce effects of difference between the two substrate holders.

The controlling of the imaging may comprise, for example, ensuring that the second pattern is imaged onto the substrate while it is held on the one of the two substrate holders on which it was held during imaging of the first pattern.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 is a schematic diagram of a dual stage lithographic projection apparatus according to an embodiment of the invention;
Figure 3 is a schematic diagram showing a ordered substrate batch for use in accordance with an embodiment of the invention; and
Figure 4 is a schematic diagram illustrating a wafer having identification markings in accordance with embodiments of the invention.

In the Figures, corresponding reference symbols indicate corresponding parts.

### Embodiments of the Invention

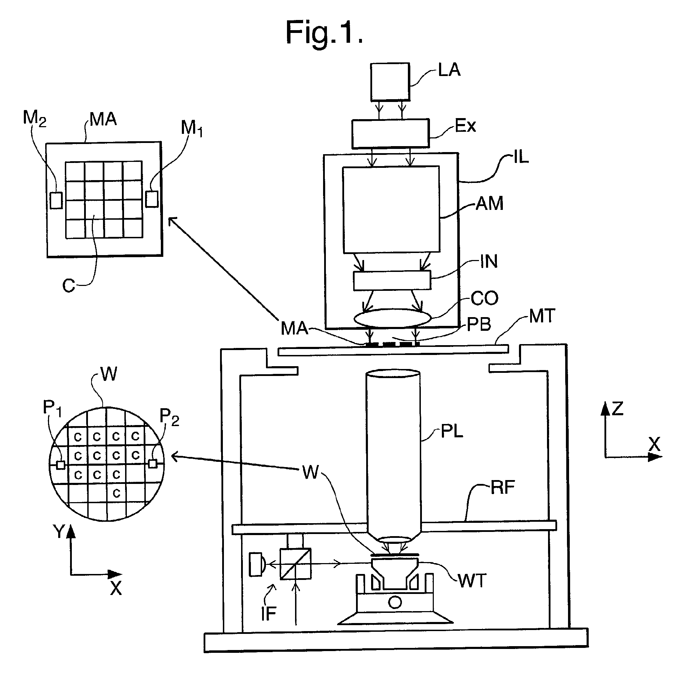

Figure 1 schematically depicts a lithographic projection apparatus 1 according to a particular embodiment of the invention. The apparatus comprises:
. a radiation system Ex, IL, for supplying a projection beam PB of radiation (*e.g*. UV, DUV, EUV radiation, electrons, or ions). In a particular case, the radiation system also comprises a radiation source LA;
. a first object table (mask table) MT provided with a mask holder for holding a mask MA (*e.g.* a reticle), and connected to first positioning means for accurately positioning the mask with respect to item PL, the first object table is supported by a frame BF;
. a second object table (substrate holder) WT provided with a substrate holder for holding a substrate W (*e.g*. a resist-coated silicon wafer), and connected to second positioning means for accurately positioning the substrate with respect to item PL;
. a projection system ("lens") PL (*e.g*. an optical system such as a catadioptric or refractive system, a mirror array or a set of field deflectors) for imaging an irradiated portion of the mask MA onto a target portion C (*e.g*. comprising one or more dies) of the substrate W.

As here depicted, the apparatus is of a transmissive type (*i.e*. has a transmissive mask). However, in general, it may also be of a reflective type, for example (with a reflective mask). Alternatively, the apparatus may employ another kind of patterning means, such as a programmable mirror array of a type as referred to above. The apparatus as a whole is supported by a base plate BP.

The source LA (*e.g*. a lamp or laser, an undulator provided in the path of an electron accelerator, a plasma source or an electron or ion beam source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate holder WT can be moved accurately, *e.g.* so as to position different target portions C in the path of the beam PB. Similarly, the first positioning means can be used to accurately position the mask MA with respect to the path of the beam PB, *e.g*. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed. During imaging, the reticle and substrate may be aligned using reticle alignment marks M₁, M₂ and substrate alignment marks P₁, P₂.

The depicted apparatus can be used in two different modes:
1. In step mode, the mask table MT is kept essentially stationary, and an entire mask image is projected in one go (*i.e*. a single "flash") onto a target portion C. The substrate holder WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g*. the y direction) with a speed *v*, so that the projection beam PB is caused to scan over a mask image; concurrently, the substrate holder WT is simultaneously moved in the same or opposite direction at a speed *V* = *Mv*, in which *M* is the magnification of the lens PL (typically, *M =* 1/4 or 1/5). In this manner, a relatively large target portion C can be exposed, without having to compromise on resolution.

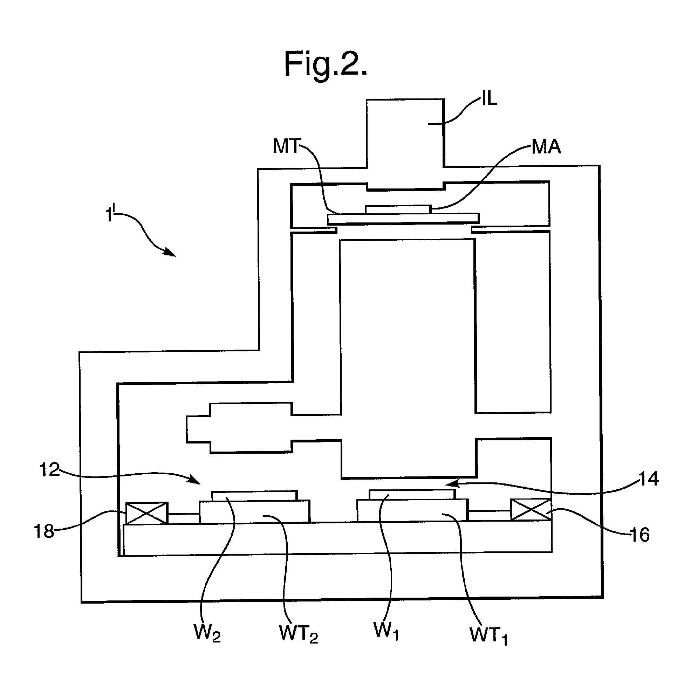

Figure 2 illustrates a particular embodiment of a lithographic projection apparatus 1' having two substrate holders in accordance with the present invention. It will be appreciated that certain systems have been simplified as compared to Figure 1, while others are shown with additional details. Those parts of the two substrate holder system that are similar to those of the apparatus 1 of Figure 1 are identified with the same reference characters. Because the apparatus depicted in Figure 2 includes two substrate holders and two substrates, these are indicated with subscripts as WT₁, WT₂, W₁, and W₂, respectively.

As shown in Figure 2, the first object table MT is configured to be movable for scanning as described above. It is, however, contemplated that, as with the single stage apparatus of Figure 1, the dual-stage apparatus of Figure 2 may be operated either in step mode or in step-and-scan mode.

The apparatus of Figure 2 further includes a characterization unit 10 that may be used to provide characterization of one substrate W₂ at a characterization position 12 while the other substrate W₁ is in an imaging position 14. The characterization unit 10 is used, for example, to measure various characteristics of the substrate W₂ such as local unflatness and die locations, and to align the substrate to its respective substrate holder. By carrying out imaging on substrate W₁ while characterizing the other substrate W₂, total throughput may be increased.

Each substrate holder WT₁, WT₂ is shown as having a respective actuator 16, 18 for moving the substrate holder during operation of the apparatus. In one embodiment, the two actuators 16, 18 move the tables within the imaging position and the characterization position, and interact to hand-off the substrate holders from one to the other. The substrates remain on their respective substrate holders during both characterization and imaging so that the characterization information remains valid during imaging.

In a batch process, several substrates are introduced into the apparatus in series. A first substrate W₁, after being characterized at the characterization position 12, is moved to the imaging position 14 for imaging. During imaging of the first substrate W₁, a second substrate W₂ is characterized at the characterization position 12. This series of operations continues for an arbitrary number of substrates Wₙ (not shown).

After the entire batch is imaged, they are typically further processed. For example, the resist is developed and etched, then metalization or dielectric layers, for example, are applied to the wafer. Next, a new layer of resist is applied and a second ( or subsequent) pattern is imaged onto the substrates. If a specific effort is not made, it is possible that the first substrate W₁ will enter the apparatus and be carried on the second substrate holder WT₂. Likewise, when the first substrate W₁ moves to the imaging position 14, the second substrate may enter the apparatus and be carried on the first substrate holder WT₁. Thus, each substrate will end up being characterized and imaged while supported by a table different from the one that supported them during the first imaging process.

Because the two substrate holders may not be exactly alike, some degree of error may be introduced into each of the characterization and imaging processes. Overall, these errors can cause error in image overlay between a first and second (or subsequent) imaging process. Furthermore, in a typical chip manufacturing process, there may be 20 or more layers imaged. It is possible that certain of these layers are imaged on one table and certain of the others are imaged on the other. Therefore, there may not be any guarantee that any particular layers will have optimal overlay relative to any other particular layers.

In accordance with an embodiment of the present invention, the projection apparatus 1' includes means for reducing effects of differences between the two substrate holders. In a specific embodiment, the apparatus includes means for ensuring that each substrate Wₙ is processed on a respective one of the substrate holders W₁ or W₂ for each lithographic processing step. Alternately, in the case that overlay is not crucial between all layers, the process may be controlled to ensure that each substrate Wₙ is processed on a respective one of the substrate holders for each layer that is determined to be a "critical" layer, wherein the peak performance is required.

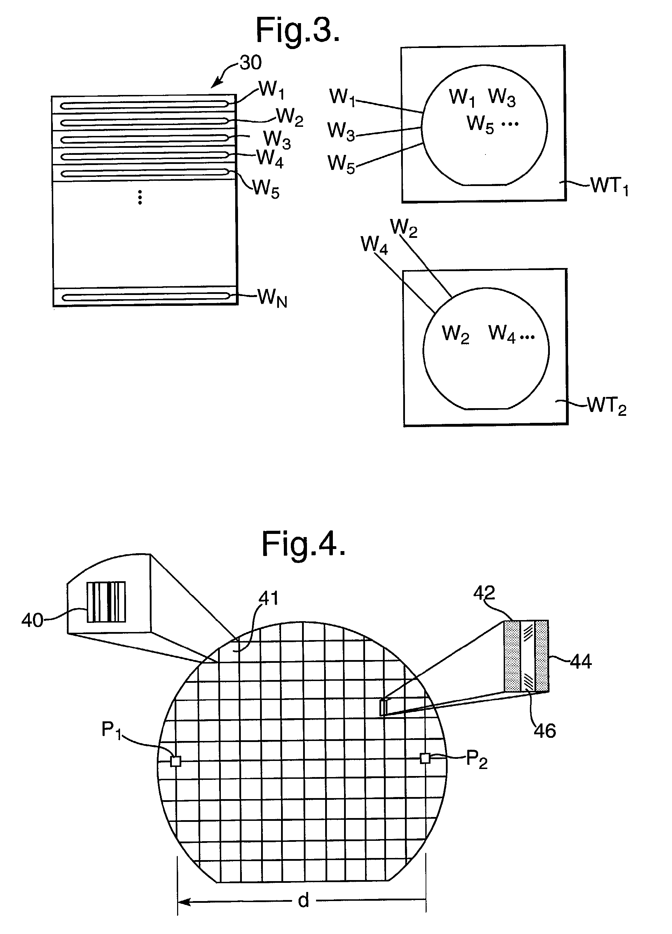

One manner in which the apparatus can ensure that a particular substrate is processed on a particular substrate holder is to include a substrate cassette 30, or other storage structure in which a plurality of substrates may be stored for processing as shown in Fig. 3. The substrate cassette 30 contains the substrates in a predetermined order such that, for example, the first substrate W₁ will always be processed first, and the second substrate W₂ will always be processed second, and so on for substrates through Wₙ. It can be appreciated that as long as the order of the substrates is maintained in a known manner, each substrate can always be matched to its respective substrate holder for processing. By way of example, the cassette may include a series of substrates, W₁, W₂, W₃, W₄, W₅ ..., Wₙ to be processed. Each odd numbered substrate is then processed on the first substrate holder WT₁ and each even numbered substrate is processed on the second substrate holder WT₂. In subsequent imaging processes, as long as the even and odd substrates are alternated, the appropriate substrate may be matched to its respective holder. As is apparent, the use of a particular storage structure is not required, but rather a variety of methods of maintaining a known order of the substrates may be employed.

In lieu of physically alternating the substrates, a handling arm or arms of the lithographic apparatus can be programmed to select the appropriate substrate from a storage location in any order necessary to maintain a relationship between the holder and the substrates. In this case, it may be preferred to allow a user to identify in advance which substrate holder will be used to process each substrate. This may be performed as part of the batch definition or as part of a set-up procedure via, for example, an administration system which may be a computer control system for a fabrication facility comprising one or more lithographic projection apparatus together with track and thermal processing apparatus.

It is often the case that, following exposure, processing of substrates is sequential. In other words, each step of the processing operates in a first in first out manner such that following processing the substrates will be in the same order W₁, W₂, W₃, W₄, W₅...., Wₙ that they were in immediately after exposure. Where it is known that processing steps applied to a batch of substrates are sequential, then a storage structure as described above may not be required. The order of the substrates remains intact as a direct result of the sequential processing. The substrates may be returned to the lithographic projection apparatus without being held in storage (i.e. immediately after processing), or may be held in a conventional storage structure (provided that the order of the substrates is not altered by the storage structure). When the substrates are returned to the lithographic projection apparatus it is required that the first substrate be passed to the correct substrate holder WT. Provided that this is done all subsequent substrates will be passed to the correct substrate holder WT. There are several methods whereby the correct substrate holder may be identified for the first substrate. For example, the lithographic projection apparatus may be configured such that the first substrate of every batch is processed on the first substrate holder WT₁. This would mean that whenever a batch is returned to the lithographic projection apparatus, the first substrate of the batch is again processed on the first substrate holder WT₁. In an alternative method, information regarding each batch may be retained following an exposure, and then retrieved when the batch is returned to the lithographic projection apparatus. The information may comprise a batch identifier together with a record of the first substrate holder used for the batch, and may for example be retained at the lithographic projection apparatus. Where this is done the administration system may track the location of the batch and notify the lithographic projection apparatus of the identity of the batch when it is returned to the lithographic projection apparatus. The identity of the batch is used, with the information retained at the lithographic projection apparatus, to determine the substrate holder to which the first substrate of the batch should be passed. In a further alternative method, the batch identifier together with a record of the first substrate holder used for the batch may be retained by the administration system, and when the batch is returned to the lithographic projection apparatus, the administration system may use this to instruct the lithographic projection apparatus to pass the first substrate to the correct substrate holder.

In the above described embodiments of the invention, there is some reliance upon the sequence in which substrates pass to the lithographic projection apparatus being unaltered. There may be some instances in which the sequence could be altered, for example if a defective substrate is identified during substrate inspection. In conventional lithographic processing a defective substrate would be removed, thereby modifying the sequence and preventing correct functioning of the embodiment of the invention. This problem may be solved in several ways. For example, the defective substrate may be retained in its place in the batch; that is it is processed as normal and is removed once all lithographic processes have been completed (i.e. all layers have been exposed). Alternatively, the defective substrate may be taken out and replaced by a dummy substrate. In a third alternative method, the substrate may be removed in the conventional way, but with a record being retained of which substrate was removed from the sequence. This record is used by the lithographic projection apparatus, either directly or via instructions from the administration system, to modify accordingly the sequence in which the substrate holders are used. In a further alternative method, when a substrate from a batch is removed from the sequence, the remaining substrates can be re-ordered so as to maintain the proper relationship between the substrates and the substrate holders.

In an alternate embodiment, each substrate has an identification mark thereon. Figure 4 illustrates some alternative markings that may be used to identify a substrate. The illustrated markings are not exhaustive and a variety of identification markings could be employed. A bar code or another machine-readable code 40 can be printed onto the substrate as shown in Figure 4. In the illustrated example, the code 40 is printed onto a die 41 that will not be used because it will not be completely imaged. A complete die could be used, though this may not be preferred due to the wasted substrate. The code 40 may simply include information indicating to what substrate holder this substrate is assigned, or it may include additional information such as a machine identifier, a batch number, a process type or any other information that might be desirable to associate with the substrate.

The code may be a substrate identification code written as a series of character which may be recognized using an appropriate detector and optical character recognition software. The detector may be located externally of the lithographic projection apparatus, for example in a track adjacent to the apparatus, with the substrate identification code being determined and then passed to the lithographic projection apparatus to allow the apparatus to select the appropriate substrate holder for that substrate. The lithographic projection apparatus selects the appropriate substrate holder using records retained at the apparatus which indicate which substrate holder was used previously for that substrate. Alternatively, the necessary records may be retained by the system administrator which, upon receiving the substrate identification code, determines the appropriate substrate holder and issues instructions to the lithographic projection apparatus accordingly.

One alternative location for a code is in the space between two dies 42, 44. In a typical lithographic process, dies are separated by lines, called scribe lines, that do not contain portions of the chips being patterned. Within the space of the scribe lines, various alignment marks 46 are sometimes imaged for use in controlling the lithographic process. It is contemplated that this space could be used to insert a code 40 as previously described.

Codes which may be read using an alignment detector of the lithographic projection apparatus are advantageous because they allow the information regarding the substrate to be determined internally within the lithographic projection apparatus, instead of relying on external input from for example a track or a system administrator. It will be appreciated that a suitable dedicated detector may be provided within the lithographic projection apparatus (see further below).

In another embodiment, the alignment marks P₁ and P₂ are encoded with the identification information. For example, the distance between the marks d can be changed such that the appropriate substrate holder may be identified. Thus, for a distance d₁, the apparatus can determine that the substrate should be processed on the first substrate holder WT₁, while for a different distance d₂ the apparatus determines that the substrate should be processed on the second substrate holder WT₂. It is contemplated by the inventors that the amount of change in position in the alignment marks will in some cases be limited by the requirements of the machine. For example, in certain machines the alignment system has a limited "capture range" within which it will detect the marks. Thus, for such a system, the marks should be shifted by less than the capture range. Moreover, because alignment marks normally have some variation in position and because there is often some variation in detected position, the marks should be shifted by more than the expected level of uncertainty of the alignment measurements. By way of example, the shift may be in the range of a few microns (e.g. 1-2 µm).

Additionally, other alignment features could be used to identify a wafer. For example, a distance between parts of a single alignment mark or between a particular part of one alignment mark and a corresponding part of another alignment mark could be used. By way of example, in the case that an alignment mark incorporates a grating, the grating spacing could be altered to allow association of a substrate with a particular substrate holder selected from a plurality of substrate holders.

For the foregoing embodiments using identification information encoded onto the substrate, the lithographic apparatus 1 may incorporate appropriate detecting means. Some examples include a separate bar code reading system, a video camera, microscope, or the alignment system. The detecting system may be incorporated into other parts of the apparatus such as the imaging system (e.g., illumination and/or projection system), the characterization unit 10 (e.g., alignment system) or in another system that inspects the substrate prior to its entry into the lithographic apparatus. Other detecting means may be appropriate depending on the type of identification information used.

It will be appreciated that, if it is known that the sequence of the substrates has not been altered during processing or storage, then it is necessary only to identify the first substrate of the batch, subsequent substrates will automatically be processed using the appropriate wafer holder. Similarly; if the sequence of the substrates has been modified in a known way, then it is again necessary only to identify the first substrate of the batch. If the sequence of the substrates is entirely unknown then each substrate must be identified individually.

It will be appreciated that the term 'identified' may mean that a unique identity for each substrate is determined, or may simply mean that the appropriate substrate holder for each substrate is determined.

In operation of a particular embodiment, an arbitrary substrate Wₙ is selected for processing. The selected substrate is identified to determine which is the appropriate substrate holder. Next, the identified substrate may be moved to the appropriate substrate holder and processed. In the case where the identification is made while the substrate is already mounted on a holder (such as when the characterization unit is used to identify the substrate), it may already be on the correct holder. In this case, the substrate is not moved, but is processed directly.

Alternatively, the identified substrate may be processed on the other substrate holder, that is, the holder that has not processed it in the past. In this case, imaging correction is applied to the imaging in order to reduce the effects of differences between the substrate holders.

Imaging correction may comprise a variety of techniques as understood by one of ordinary skill in the art. For example, it may be possible to characterize the overlay problems observed between a given pair of substrate holders. That is, it is possible that there is a set of positional vectors that can be determined that, if applied to an image made on one substrate holder would produce the same image as would have been made on the other substrate holder. In the case that such a relationship can be determined, the imaging process can be modified in order to reduce the effects of the differences. In one embodiment, a vector map or other characteristic difference information can be stored in a memory of the lithographic apparatus and used during processing of subsequent layers on the substrate.

In certain cases, the positional relationship between an interferometer mirror of a substrate holder and the substrate carried thereon is different between substrate holders. This may result from errors in positioning of the mirror, errors in positioning of a gripper portion of the holder (such as a pimple table), or the like. In this case, a positional or rotational difference will be perceived when a given substrate is held on the two different substrate holders. Since this reflects a physical error that is relatively consistent, appropriate corrections can be applied. Similarly, if there is a relative unflatness or tilt between the two substrate holders, appropriate programming of the imaging operation may successfully reduce overlay errors.

Although the invention has been described in relation to a lithographic apparatus having two substrate holders, it will be appreciated that the invention may be applied to a lithographic apparatus having any number of substrate holders (i.e. any number except 1).

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- a support structure for supporting patterning means, the patterning means serving to pattern the projection beam according to a desired pattern;
- a first substrate holder for holding a substrate;
- a second substrate holder for holding a substrate;
- a projection system for projecting the patterned beam onto a target portion of the substrate,
**characterized in that** the apparatus further comprises means for controlling imaging such that when imaging a second pattern onto a substrate having a first pattern imaged thereon, effects of differences between the two substrate holders are reduced.

2. Apparatus as in claim 1 wherein, during use, one substrate of a plurality of substrates is imaged while held by the first substrate holder and another substrate of the plurality of substrates is held by the second substrate holder.

3. Apparatus as in any one of the preceding claims wherein the means for controlling imaging compromise means for ensuring that a substrate on which the first pattern is imaged will be imaged with the second pattern using the same one of the two substrate holders.

4. Apparatus as in any one of the preceding claims wherein the means for controlling imaging comprise means for adjusting the imaging to account for differences between the substrate holders.

5. Apparatus as in any one of the preceding claims further comprising identification means for inspecting a substrate to determine substrate identification information prior to imaging.

6. Apparatus as in claim 5, wherein the identification means comprise an alignment system of the apparatus.

7. Apparatus as in claim 5, wherein the identification means comprise at least one of a bar code reader, a machine vision system, a video camera, a microscope and combinations thereof.

8. Apparatus as in any one of the preceding claims, further comprising means for receiving substrate identification information from a source outside of the lithographic projection apparatus.

9. Apparatus as in any one of the preceding claims, further comprising storage means configured to store substrate identification information together with associated substrate holder information.

10. Apparatus as in any of claims 5 to 9, wherein the substrate identification information comprises information regarding the first substrate of a batch of substrates.

11. Apparatus as in any one of the preceding claims, further comprising means for receiving instructions indicating which substrate holder must be used when imaging the second pattern onto the substrate, or instructions indicating how to adjust the imaging to account for differences between the substrate holders.

12. A device manufacturing method comprising the steps of:
- providing a substrate that is at least partially covered by a layer of radiation-sensitive material on a first substrate holder of a lithographic apparatus having at least first and second substrate holders;
- providing a projection beam of radiation using a radiation system;
- using patterning means to endow the projection beam with a pattern in its cross-section;
- projecting the patterned beam of radiation onto a target portion of the layer of radiation-sensitive material to image a first pattern,
**characterized by**:
imaging a second pattern onto the substrate; and
controlling the imaging of the second pattern to reduce effects of differences between the two substrate holders.

13. A method as in claim 12 further comprising:
imaging a first pattern and a second pattern onto a second substrate held by the second substrate holder,
controlling the imaging of the second pattern onto the second substrate to reduce effects of differences between the two substrate holders.

14. A method as in one of claims 12 and 13 wherein the controlling further comprises ensuring that the second pattern is imaged onto the substrate while the substrate is held on the first substrate holder.

15. A method as in one of claims 12 to 14 wherein the controlling further comprises checking an identity of the substrate prior to the imaging of the second pattern.

16. A method as in claim 15 wherein the checked identity is used to determine upon which substrate holder the substrate has been previously imaged.

17. A method as in claim 16 wherein after the determining, the imaging further comprises one of:
placing the substrate onto the substrate holder upon which it has been previously imaged, and
adjusting the imaging to account for differences between the first and second substrate holders.

18. A method as in claim 15 wherein the checking further comprises checking stored identity information.

19. A method as in claim 15 wherein the checking further comprises determining upon which of the two substrate holders the substrate was previously processed and processing the substrate on that substrate holder.

20. A method as in claim 15 wherein the checking further comprises checking a physical identification marker on the substrate.

21. A method as in claim 20 wherein the physical identification marker comprises at least one of a bar code, alphanumeric characters, one or more symbols, and combinations thereof.

22. A method as in claim 20 wherein the physical identification marker comprises a pair of alignment marks having a predetermined spacing.

23. A method as in claim 15 wherein the ensuring further comprises ordering a batch of substrates to be processed such that each substrate is, in turn, associated with a respective one of the substrate holders on which it has previously has been processed.

24. A method as in claim 14 wherein the controlling further comprises imaging the second pattern onto the substrate while the substrate is held on the second substrate holder and adjusting the imaging to account for differences between the first and second substrate holder.

25. A method as in claim 24 wherein the adjusting is preformed on the basis of a set of stored parameters characterizing differences between the first and second substrate holders.

26. A method of determining upon which of a plurality of substrate holders a substrate has been previously imaged comprising:
imaging at least a pair of alignment marks on an area of the substrate not comprising patterns of a microcircuit, the pair of alignment marks being spaced one from the other by a distance, the distance corresponding to a particular one of the plurality of substrate holders;
during a subsequent imaging process, measuring the distance; and
correlating the distance to a particular substrate holder of the plurality of substrate holders.

27. A substrate comprising:
at least a pair of alignment features, the pair of alignment features being spaced one from the other by a distance, the distance corresponding to a particular one of a plurality of substrate holders such that upon inspection of the distance, the substrate may be associated with the particular one of the plurality of substrate holders.
